# EUROPEAN PATENT SPECIFICATION

(11) **EP 3 078 067 B1**
(45) Date of publication and mention of the grant of the patent: **05.02.2020**
(21) Application number: 14824547.5
(22) Date of filing: 08.12.2014
(51) Int. Cl.: H01L 51/44, H01L 51/42, H01G 9/20, H01L 31/0352, C08K 3/22

(54) **SOLAR PAINT MATERIAL AND PAINTING SYSTEM USING THE SAME**
SONNENLACKIERMITTEL UND LACKIERSYSTEM DAMIT
MATÉRIAU DE PEINTURE SOLAIRE ET SYSTÈME DE PEINTURE UTILISANT CE DERNIER

(30) Priority: 08.12.2013 US 201361913309 P; 30.07.2014 IL 23387014
(43) Date of publication of application: 12.10.2016
(73) Proprietor: Solarpaint Ltd., 3081500 D.N. Hof Carmel (IL)
(72) Inventor: MAIMON, Eran, 1896500 Kibbutz Ein Harod Meuhad (IL)
(74) Representative: Zacco GmbH
(86) International application number: PCT/IL2014/051069
(87) International publication number: WO 2015/083175

(56) References cited:
- WO-A1-2013/038539
- WO-A2-2004/086464
- David Martineau ET AL: "DYE SOLAR CELLS FOR REAL The Assembly Guide for Making Your Own Solar Cells", , 3 April 2012 (2012-04-03), XP55189521, Retrieved from the Internet: URL:http://www.solaronix.com/documents/dye _solar_cells_for_real.pdf [retrieved on 2015-05-18]
- "INNOVATIVE SOLUTIONS FOR SOLAR PROFESSIONALS", , 1 January 2013 (2013-01-01), XP55189523, Retrieved from the Internet: URL:http://www.solaronix.com/documents/sol aronix_materials.pdf [retrieved on 2015-05-18]

## Description

### TECHNOLOGICAL FIELD

The present invention relates to techniques for harvesting solar energy. The invention provides materials and system for operating selected surfaces as photo-voltaic surfaces.

### BACKGROUND

The demand for energy is constantly rising and various alternatives for fossil fuel becoming more and more available. The use of solar energy is becoming one of the most promising alternatives. The use of this regenerating energy source provides abundance of available energy to be converted from electromagnetic optical radiation to electrical power.

The typical, commercially available solar harvesting systems utilize a preconfigured solar panel prepared for harvesting optical energy and converting the harvested energy to electrical power. The panels are provided with suitable electrical connection to collect generated charge carriers from different regions of the panel and to direct the collected energy to the grid, a storage device (e.g. battery) and/or load.

Various types of photovoltaic systems and techniques have been developed, providing different types of solar panels as well as additional configurations for light conversion into electricity. For example:
US 2009/217,973 describes a photovoltaic device having a first electrode layer, a high resistivity transparent film disposed on the first electrode, a second electrode layer, and an inorganic photoactive layer disposed between the first and second electrode layers, wherein the inorganic photoactive layer is disposed in at least partial electrical contact with the high resistivity transparent film, and in at least partial electrical contact with the second electrode. The photoactive layer has a first inorganic material and a second inorganic material different from the first inorganic material, wherein the first and second inorganic materials exhibit a type II band offset energy profile, and wherein the photoactive layer has a first population of nanostructures of a first inorganic material and a second population of nanostructures of a second inorganic material.
US 2013/263,918 describes photovoltaic nanocomposite and solar cell device including the photovoltaic nanocomposite, where the photovoltaic nanocomposite includes a film of solution processed semiconductor materials having an n-type material selected from n-type quantum dots and n-type nanocrystals, and a p-type material selected from p-type quantum dots and p-type nanocrystals, and where the n-type material has a conduction band level at least equal, compared to vacuum level, to that of the p-type material, the p-type material has a valence band at the most equal, compared to vacuum level, to that of the n-type material. At least a portion of the n-type material and at least a portion of the p-type material are present in a bulk nano-heteroj unction binary nanocomposite layer having a blend of the n-type material and the p-type material.
WO 2013/111,160 discloses a room temperature process for the fabrication of dye sensitized solar cells (DSSCs). Particularly, the invention discloses a room temperature process for preparing easily curable, binder free titania based solar paint that gives a high conversion efficiency to be used in fabrication of DSSCs at room temperature.
WO 2013/038539 A1 discloses a wire grid electrode structure for an organic-semiconductor solar cell.

### GENERAL DESCRIPTION

There is a need in the art for an efficient technique allowing conversion of surfaces of different types to photovoltaic panels. The present invention is concerning an electrode arrangement according to claim 1 and further provides a novel technique of the kind specified based on suitable micro-structures. The technique and micro-structures described herein may be applied on any desired surface exposed to electromagnetic radiation and provide photovoltaic functionality to the surface.

Thus, according to some aspects of the present invention, it provides a micro-structure configured for use in light conversion. The micro-structure is generally configured with a junction region and at least two charge selective regions. For example the micro structure may be an anisotropic rod shaped microstructure having a first region configured of a first material (e.g. first semiconductor) and a second region made of a second material (e.g. second semiconductor). Generally, at least one of the materials, or the combination of the materials, has an absorption spectrum that coincides with at least part of the solar spectrum thus allowing absorption of ambient light impinging on the microstructure. An interface between the first and second regions provides a junction region is configured to cause separation of charge carriers generated by the absorption between the first and second regions.

According to some other examples, the microstructure may be configured as an anisotropic three-dimensional structure, which comprises regions configured for generation of free charge carriers in response to absorption of input electromagnetic radiation of one or more wavelength ranges and separation between the different charge carriers. A plurality of such micro-structures may be applied on a desired surface to easily convert the surface to a photovoltaic surface generating free charge carriers in response to input electromagnetic radiation. The generated free charge carriers may be collected by an appropriate specific wiring along the surface to provide electrical energy.

Additionally, the present disclosure also provides a liquid-phase substance, which may include, or come in contact with, a plurality of anisotropic micro-structures configured for generating free charge carriers in response to input electromagnetic radiation. Such liquid substance may be easily applied on a surface, and upon hardening it by application of heat thereto (e.g. via applied electromagnetic radiation and/or temperature field for curing or drying the substance), the micro-structures remain distributed along the surface while being attached thereto.

Additionally, the liquid substance / mixture may comprise suitable conduction-selective compounds, which are configured to interact with suitable regions of the micro-structures and sustain such interaction for long time after hardening of the liquid mixture on the surface. The conduction-selective compounds are selected to be capable of providing charge selective transmission of free charge carriers from the micro-structure to its surroundings. More specifically, the liquid mixture may comprise at least first and second types of conduction-selective compounds selected such that the first compound type is configured to allow electron conduction from the micro-structure to a specific electron conducting material in the surrounding medium, and the second compound type is configured to allow conduction of holes from the micro-structure to a specific hole conducting material in the surrounding medium. The configuration of such microstructures is described more specifically further below.

Moreover, the present invention provides an electrode arrangement, which is configured to collect generated free charge carriers from the "photovoltaic" surface described above or in general from any photovoltaic surface as the case may be. The electrode arrangement comprises at least two sets of conducting wires, each being configured (e.g. treated with a suitable coating) to selectively allow collection of charge carriers from surroundings thereof. The at least two sets of wires are configured to be spread along the surface from which the charge carriers are to be collected. The different sets of conducting wires are preferably arranged along the regions for collection of charge carriers generated therein and are overlying one over the other within the selected region while being insulated from one another.

It should be noted that the at least two sets of wires may be configured such that a first wire set allows collection of positive charge carriers (i.e. holes, cations, etc.). This is while a second wire set allows collection of negative charge carriers (i.e. electrons, anions, etc.). To provide this charge selectivity, the first and second wire sets may be coated with charge transmission selective materials. Such materials may include electron blocking coating for the first wire set and hole blocking coating for the second wire set. For example, NiO coating may be applied on the first set of wires to prevent electron collection. The second set of wires may be coated with Zinc Oxide (ZnO) layer to thereby prevent holes' collection and allow electron collection by the second set of wires.

The liquid mixture/substance, micro-structures (and conduction-selective compounds) and the electrode arrangement may be assembled to provide a kit for use in preparation of the photovoltaic-converted surface. The kit comprises the liquid mixture and micro-structures for application to the desired surface as a paint layer. Additionally, the electrode arrangement can be stretched along the surface for collecting free charge carriers generated by the micro-structures.

More specifically, the micro-structure is generally configured as a three-dimensional structure having at least three functionally different regions including at least one absorption region for absorption of incident electromagnetic radiation of one or more predetermined wavelength ranges, and at least two charge selective transmission regions for transferring the free charge carriers generated by the light absorption. The micro-structures are configured such that input light, absorbed in the absorption region, generates a pair of charge carriers that are transferred away from each other across the junction region and the charge selective transmission regions transfer the so-generated charge carriers away to allow the charge collection.

In some examples, the micros-structure is configured to define at least three arms, which extend from a common interface / point along at least three different intersecting axes, respectively. These at least three arms may be configured as the above mentioned at least three functionally different regions, respectively. Alternatively, the configuration may be such that the two of such arms are configured and operable as the different charge selective transmission regions, respectively, while the extensions of these regions form together the third arm which serves as the absorption region.

Generally, the technique and elements described herein may be used for simple and easy conversion of any desired (non-conductive) surface to a solar collection surface. The conversion process is as simple as laying the associated electrode arrangement for charge collection on the desired surface and painting the surface, covered with electrodes, with the micro-structures' containing liquid mixture. The mixture might need hardening (e.g. curing), as well as may also need alignment of the micro-structures for optimized performance in accordance with the actual material composition and configuration of the structures.

Thus, according to one aspect of the invention, there is provided a micro-structure for use in light conversion, the micro-structure having an anisotropic three-dimensional configuration comprising:
at least one absorption region configured for absorption of input light of a predetermined wavelength range and generating in response free charge carriers;
at least a pair of selective charge transmission regions comprising at least one region configured to allow transmission of free electrons and at least one region configured to allow transmission of holes, the selective charge transmission regions of said pair may be connected between them via an interface formed by said at least one absorption region;
the micro-structure being therefore configured to convert the input light of said predetermined wavelength range, absorbed by said at least one absorption region, into a charge flow of electrons and holes through the selective charge transmission regions.

The anisotropic three-dimensional configuration may be such as to define at least three arms corresponding to, respectively, the at least one absorption region and the at least pair of the selective charge transmission regions.

The selective charge transmission regions may be regions of the same semiconductor material composition having n and *p* type doping, respectively, to provide the selective conduction to the charge carriers. Alternatively, the selective charge transmission regions may be formed of first and second semiconductor material compositions, for example ZnO and CuO. In this case, the configuration is such that the absorption of light occurs at a region of at least one of the materials or in the interface between them, and the interface between materials (hetero-junction) induces charge separation between the first and second semiconductor material compositions. Additionally the selective charge transmission regions are configured from suitable (e.g. hole/electron selectively conductive) semiconductor material compositions respectively. For example, the absorption and separation region may be a core-shell structure of first and second semiconductor materials, while extensions of the first and second semiconductor materials from said core-shell structure along first and second intersecting axes define the selective charge transmission regions.

The micro-structure may further include orientation mechanism configured to vary orientation of the micro-structure in response to an applied external field. This may for example be a magnetic element which, in response to applied magnetic field, applies a rotation force causing rotation of the micro-structure. This enables orienting the micro-structure in accordance with a direction of the magnetic field.

As indicated above, the micro-structure may further include conduction-selective compounds configured for transmission of negative and positive charge carriers (e.g. electrons and holes) respectively, and interacting with the selective charge transmission regions, thereby allowing charge collection from the micro-structure. The conduction-selective compounds may comprise polymeric compounds, such as Poly-(3,4-ethylenedioxythiophene) (PEDOT) and Poly-(benzimidazobenzophenanthroline) (BBL) polymers, as well as may comprise polymeric and sol-Gel compounds, for example, Poly(3,4-ethylenedioxythiophene) (PEDOT) for holes conduction and ZnO sol-Gel for electron conduction. Alternatively or additionally, the micro-structures may comprise a porous material (for example metal) or conductive aerogel. Surface of the pores may be coated by hole or electron selective conductor. This is while that pores are filled with the opposite carrier transport material (e.g. Ionic Liquids (ILs), Hole Transport Materials (HTMs) or Conductive Gels (CG)). Thus, generally the micro-structures of the present invention are configured with two or more materials forming together an interpenetrating conductive structure where the two or more materials are each electrically conducting; however, the materials are electrically isolated from each other with respect to charge carriers.

According to another aspect of the disclosure, there is provided a liquid substance comprising a solution with a plurality of micro-structures immersed therein configured as described above, the liquid substance being configured to enable its application on a surface to thereby disperse the micro-structures on the surface.

According to yet another aspect of the disclosure, there is provided a liquid substance comprising a plurality of micro-structures immersed therein and being configured for applying on a surface to disperse the micro-structures on said surface, wherein:
said plurality of micro-structures are configured as anisotropic micro-structures adapted for absorbing input light of a predetermined wavelength range and generating, in response, electron-hole pairs of free charge carriers; and
at least first and second types of compounds configured to attach to selective regions of the anisotropic micro-structures, and to allow conduction of, respectively, electrons and holes from the microstructures.

According to yet further aspect of the invention, there is provided an electrode arrangement comprising at least two sets of conducting wires comprising different wires configured for transmitting charge carriers of two different types respectively, from a medium in surroundings thereof, wherein said at least two sets of conducting wires are arranged in the form of a grid such that the different wires overlay about one another defining a region of charge collection, and are insulated from one another in said region of charge collection.

For example, the different wires of the two sets are coated with selective charge carriers blocking layers, respectively.

The wires of the two sets may be weaved together within the region of collection.

The electrode arrangement is typically configured for defining a plurality of the collection regions, such that within each of the collection regions the at least two sets of conducting wires are insulated from each other, and the at least two sets of conducting wires are connected either in parallel or in series between the collection regions to thereby provide accumulating voltage of charge collection.

The conducting wires may be configured as coaxial wires having predetermined capacitance between an outer conducting shell and an inner conducting axial segment thereof.

According to some embodiments, the electrode arrangement may be configured such that at least one of said at least two sets of wires comprises charge selective coating and wherein a plurality of micro-structures are grown from said charge selective coating. Said plurality of micro-structures being configured for absorption of light of a predetermined wavelength range and causing charge separation to thereby allow collection of charge carriers through said at least one of the at least two sets of wires. Generally charge carriers may be transmitted to the corresponding wires directly, i.e. through contact of the corresponding end of the micro-structure with the wire, or through electrically conducting elements of the paint material. For example, the at least one of said at least two sets of wires may be coated with ZnO or Titania (Titanium dioxide) or ZnO coated with Titania, said micro-structures comprising a regions formed of ZnO (or Titania) being attached to said coating. This is while one other end of the micro-structures may be coated with CuO to provide the heterojunction for absorption and charge separation. In such configuration, PEDOT coating for the second wire may be used to allow conduction of holes (positive charge carriers) thereto.

Generally, according to some embodiments of the invention, at least one of said at least two sets of wires is coated with a selective charge carriers blocking material comprising at least one material selected from: Unary, binary or ternary n-type semiconductor of groups IV, III-V, II-VI, PEDOT, PDI, PCBM, ZnO, TiO2 and n-doped Tin Oxide. At least one other of said at least two sets of wires may be coated with a selective charge carriers blocking material comprising at least one material selected from: Unary, binary or ternary p-type semiconductor of groups IV, III-V, II-VI, BBL, PDOT, BBB, CBP, NiO, TPD, Poly TPD, and Spiro-OMETAD.

According to yet further aspect of the invention, it provides a kit for use in preparation of a photo-voltaic surface, the kit comprising:
a paint material applicable on an electrically insulating surface, the paint material comprising a liquid substance with immersed plurality of anisotropic micro-structures configured for absorbing input light of a predetermined wavelength range and generating, in response, electron-hole pairs of free charge carriers, and charge selective compounds configured to attach to selective regions of the anisotropic micro-structures, and to allow conduction of, respectively, electrons and holes from the microstructures, application of said paint material to the surface and hardening thereof resulting in dispersion of the micro-structures within said surface and attachment to said surface; and an electrode arrangement configured for placing on said surface, the electrodes arrangement comprising at least two sets of conducting wires comprising different wires configured for transmitting charge carriers of two different types, respectively, from a medium in surroundings thereof, such that when the paint material is applied to the surface on which the electrode arrangement is placed, the electrodes arrangement defines an array of charge collection regions for collecting the charge generated in response the input light absorbed by the micro-structures.

The kit may further include a source of a predetermined field (e.g. magnetic field source) to affect orientation of the anisotropic micro-structures; as well as may include a suitable paint hardening unit (e.g. curing unit).

### BRIEF DESCRIPTION OF THE DRAWINGS

In order to better understand the subject matter that is disclosed herein and to exemplify how it may be carried out in practice, embodiments will now be described, by way of non-limiting example only, with reference to the accompanying drawings, in which:
**Fig. 1** illustrates conversion of a desired surface to provide photovoltaic energy harvesting according to the present invention;
**Figs. 2A to 2C** illustrate a schematic configuration of photovoltaic micro-structures according to some embodiments of the present invention, having 2-region configuration (Fig. 2A), anisotropic 3-region configuration (Fig. 2B) and an energy band structure allowing charge separation in such micro-structures (Fig. 2C);
**Fig. 3** illustrates configuration of a micro-structure according to some embodiments of the invention, having a core-shell cylindrical configuration of the absorption region;
**Fig. 4** illustrates a micro-structure according to some embodiments of the invention including charge selective compounds attached (by ligands) to surface regions of the micro-structure;
**Fig. 5** illustrates an electrode arrangement configured for charge collection from a converted surface according to some embodiments of the invention;
**Fig. 6** illustrates micro-structure grown from charge selective coated wire according to some embodiments of the invention; and
**Figs. 7A-7B** illustrates a simulated current density as a function of voltage [J/V] diagram for a micro-structure based solar cell of the invention to exemplify calculation of the theoretical quantum efficiency and fill factor.

### DETAILED DESCRIPTION OF EMBODIMENTS

Thus, the present invention in some of its aspects provides micro-structures suitable for use in photo-voltaic energy conversion. According to the technique of the invention, a liquid-phase substance containing these micro-structures can be applied on a desired surface, exposed to input electromagnetic radiation, to convert this surface into a photovoltaic surface capable of converting input electromagnetic radiation to electrical energy.

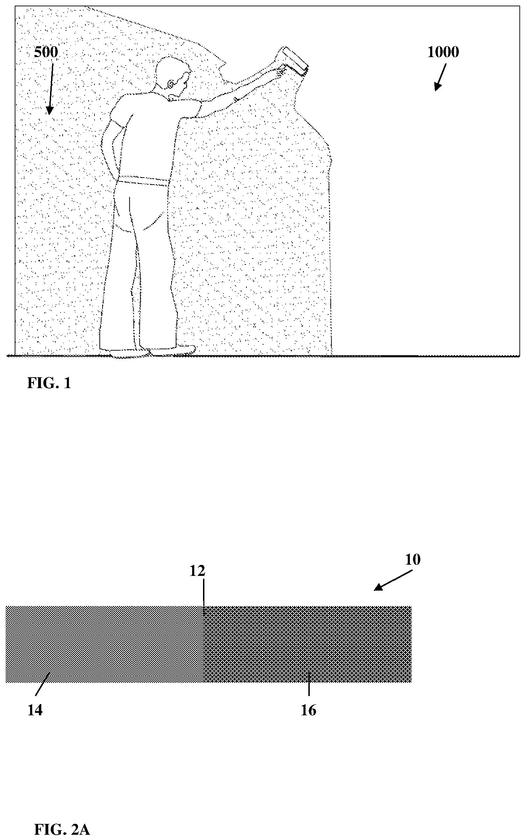

Reference is made to **Fig. 1** illustrating painting of a surface **1000,** within a region **500** thereof, exposed to solar radiation, with a liquid substance of the present invention to thereby allow the painted surface region **500** to convert the input radiation incident thereon into electrical energy. Construction and material composition of the micro-structures as well as the liquid mixture providing the paint material and charge collection techniques will be described in more details further below.

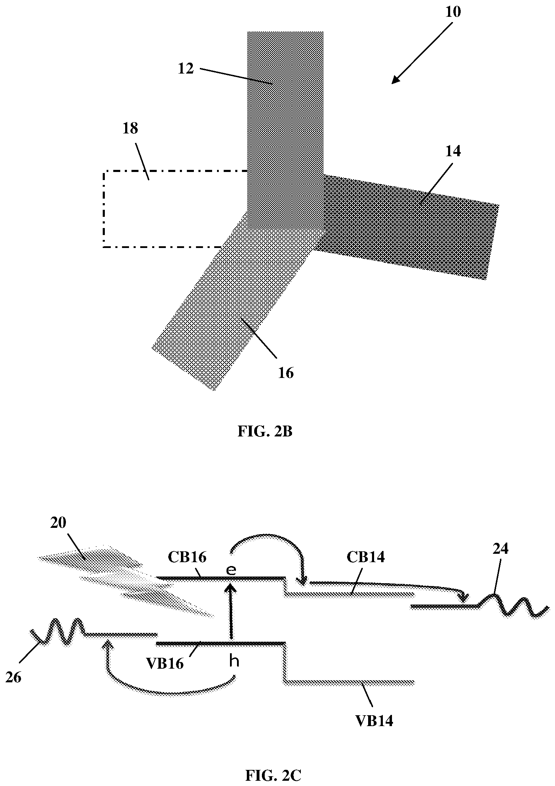

Reference is made to **Figs. 2A** **and** **2C** schematically illustrating a configuration of two examples of micro-structure particles **10** according to some embodiments of the present invention. **Fig. 2A** illustrates an anisotropic rod shaped micro-structure **10;** **Fig. 2B** illustrates an anisotropic complex micro-structure **10** and **Fig. 2C** illustrates an energy band structure of the micro-structures. As shown, the micro-structure **10** of **Fig. 2A** is configured as a rod shape micro-structure configured of at least two regions of different electronic properties (generally two different materials or differently doped material) regions **14** and **16** in this example. An interface **12** between the first **14** and second **16** region provides a junction causing charge separation in response to absorption of light (of suitable wavelength range). The material selection for regions **14** and **16** provides that free electrons, generated due to light absorption, will move towards electron conduction region **14.** This is while free holes will move towards hole conduction region **16.** It should be noted that the micro-structure may be configured from a rod shaped structure of a first material (e.g. electron conducting material), having a suitable coating of the second material on a section thereof. Generally, at least one of the materials forming the first **14** and/or second **16** regions or the junction/interface **12** between them has suitable electronic structure to provide effective light absorption is at least one predetermined wavelength range. Such wavelength range may e.g. include visible light.

**Fig. 2B** illustrates an additional configuration of the micro-structure **10** having a multi (three or more) arms configuration. As shown, the micro-structure **10** is formed as an anisotropic particle containing at least one light absorption region (arm) **12,** which may be a hetero-junction or not, and at least two charge selective regions (arms) **14** and **16** including at least one electron conduction region and at least one hole conduction region configured to allow conduction of electrons and holes, respectively, away from the absorption region **12.**

In some configurations, the micro-structure **10** also includes at least one additional region **18** being an orientation region (shown in dashed line). The orientation region (arm) **18** includes an orientation element / mechanism configured to affect the orientation of the micro-structure in response to an external field. For example, the region **18** may include a magnetic element / material thus allowing control of the orientation of the micro-structure by appropriately applying the field, in this example a magnetic field.

The micro-structure **10** may generally be an anisotropic rod shaped structure or an anisotropic structure having a three-dimensional structure, configured with predetermined geometry and/or material composition as illustrated for example in **Figs. 2A** **and** **2B****,** suitable to provide charge separation. More specifically, upon absorption of light in the absorption region **12,** an electron-hole pair is generated in the vicinity of the absorption region. The geometry and/or material composition of the micro-structure is/are selected such as to direct the generated free electron along the electron-conduction region **14** and the hole along the hole-conduction region **16.** The micro-structure may generally be in the order of microns or smaller in size, e.g. the three-dimensional structure may fit into a sphere in the order of 10⁻⁷-10⁻⁶ meters in diameter (or a rod of about 100-5000nm). It should be noted though, that the size of the micro-structure is preferably determined in accordance with the absorption coefficient of the absorption region **12** or the region configured of suitable absorbing material as in the example of **Fig. 2A****.** The absorption coefficient is a parameter of the material composition use and relates also to the structure of the absorbing region. Additionally, parameters such as exciton radius within the materials used and the required charge separation for efficient charge collection may also be used to determines size and structure of the micro-structure to provide efficient light conversion.

In some examples, the micro-structure has the absorption and charge transferring regions of the length of 100nm to 5µm, preferably of the length of 200nm to 2 µm. Each such arm may be of 10-500nm radius, while the different arms may have different radii, e.g. the absorption region may be wider (of larger radius) as it may be in the form of a light absorbing shell around a core having appropriate electronic transport properties. The different arms may be attached together and oriented with respect to each other with angular relations of 70° to 130°, and preferably of 90° to 115°. According to some embodiments, the micro-structure has three-dimensional tetrahedral shape with angles of about 109° between the arms.

In this connection, **Fig. 2C** illustrates an example of the energy band structure of the micro-structure according to some embodiments of the invention. In this example, the micro structure includes at least two regions different between them in the affinity conduction for positive (holes) and negative (electrons) charge carriers, and an absorption region, which interfaces between the at least two charge transferring regions. A photon **20** being absorbed at the absorption region excites an electron from the corresponding valance band **VB16** to the conduction band **CB16** thus generating an electron-hole pair. The excited electron is transmitted through conduction band states at the electron conducting region **CB14** and can later be collected by an electron conducting matrix material (compound) connected / attached to the electron conducting compound for example through ligands **24.** Similarly, the generated hole propagates along the valance band of the hole conduction region **VB16** to be collected by a hole conducting compound interacting with region **VB16** for example through ligands **26.**

The micro-structure may be configured as a rod having two regions of different electronic transport properties, i.e. one region having energy band structure preferring electron transport with respect to the second region (which has electronic properties preferring hole conduction). Alternatively, for example, the micro-structure may be configured with three or more connected arms (or four or more arms in the case where orientation region is included).

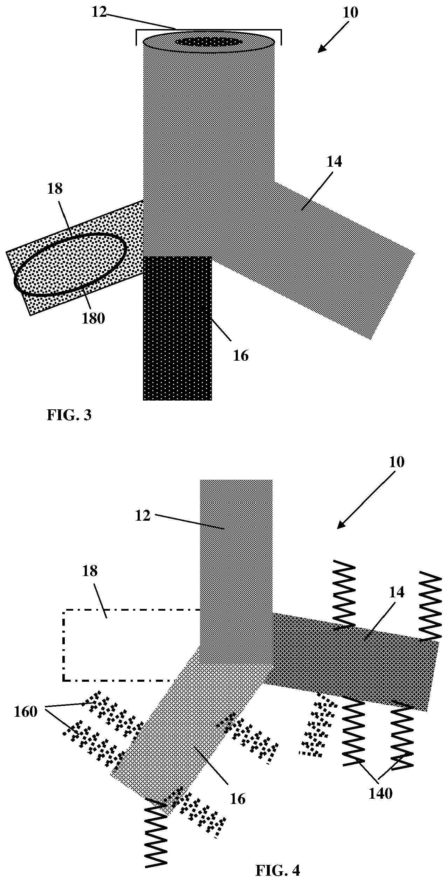

The configuration and operation principles of such a tetrahedral-like geometry structure is exemplified in more details in **Fig. 3****,** illustrating a micro-structure **10** having four arms connected at a connection zone (point). Electron **14** and hole **16** conducting arms are attached at the connection point and extend into the absorption arm/region **12.** As indicated above, the absorption region **12** presents an interface between the electron and hole conducting regions **14** and **16** to thereby provide light absorbing regions capable of supporting charge separation due to absorption. For example, as shown in the figure, the micro-structure includes the absorption arm **12** with cylindrically-like geometry, where an inner cylinder is configured with a first electric transport property, and is surrounded by an outer cylinder having a second electric transport property. Thus, in this example, the absorption region **12** is formed of two sub-regions configured of the material composition having electric transport property and the material composition having hole transport property. These sub-regions extend outside arm **12** along arms **14** and **16** respectively, thus forming electron and the hole transport functional regions, which interface with the absorption region **12.** This internal-external configuration of the absorption region provides a minimal distance for charge separation, regardless of an actual location where the electron-hole pair is generated. It should however be noted that additional interface configurations, as well as semi coated rods and other three-dimensional configurations, of the micro-structures **10** may be used.

The absorption region and the electron- and hole-conduction regions may be made of a similar material composition (e.g. semiconductor material) having different doping, such as *n* and *p* type doping. Alternatively, the different regions may be made of two (or more) different material compositions providing a heterojunction region. More specifically, the micro-structure may be a semiconductor structure (e.g. Silicon) having *n* and *p* type doping in the corresponding regions, or being configured of two different semiconductor materials differing between them in the energy-band structure and/or corresponding electric transport properties, as well as organic, polymeric, or small molecule type semiconducting materials. However, it should be noted that at least one of the hole- and electron-conducting material compositions or the junction region formed between them is selected to be light absorbing for at least one wavelength range.

For example, the micro-structure may be formed of one or more variations of Copper Oxide (A_{z}CuₓO_{y} generally referred herein as CuO) as hole-conducting material composition and one or more variations of Zinc Oxide (B_{z}ZnₓO_{y} generally referred herein as ZnO) as electron-conducting material composition. In such configuration, the absorption region is preferably configured to be heterojunction such that the CuO shell is external with respect to the ZnO inner (core) region to provide enhanced absorption properties at the interface region. Specifically, according to some configurations, the inner cylinder (core) of ZnO may be formed with a diameter of 10-20nm, while the external CuO region provides a 5-15nm shell surrounding the inner ZnO region. Additionally, the electron- and hole-conduction regions (**14** and **16** in the figure) may be formed as extension of the absorption region's structure.

It should be noted that generally, the micro-structures of the present invention may be formed by various suitable material compositions, and specifically semiconductor materials, selected in accordance with their electronic transport properties. These materials can include, but not limited to, TiO₂, SiC, Mn/Mg doped TiO₂, Mn/Mg doped ZnO, AlCuO Cu₂O, and all Groups IV, Group III-V, and Group II-VI semiconductor binary, ternary or higher compounds and alloys, or core-shell-like configurations, as well as organic, polymeric, or small molecule type semiconducting materials.

The general route for synthesis of the heterostructure micro-structures is a growth of a base micro-structure from one material followed by selective growth of the second material on top of specific parts of the base micro-structure, or alternatively partial cations exchange at specific locations of the base micro-structure, both resulting in a micro-structure that contains two (or more) distinctive regions. According to some embodiments, such heterostructure might be of a cylindrical-like core shell configuration. An example for all solution synthesis of microstructures is a colloidal growth of ZnO (or doped ZnO) tetrapods from Zn complexes (precursors) in organic solution, followed by selective growth or selective cation exchange in a Langmuir Blodgett film on a aqueous/organic interface, to form CuO coating on specific regions. Additional approach for synthesis can be an epitaxial growth of ZnO dots from soluble Zn salt on glass/quartz solid support or by pyrolysis (heating in air), followed by growth of ZnO rods from the seeded surface by CBD (chemical bath deposition), this will be followed by CuO growth in CBD or alternatively by cation exchange to coat the rods with CuO. Finally, the heterostructure nanorods are removed from the solid support and transferred to an organic solution for the growth of additional ZnO arms to create heterostructure tetrapods.

To provide conversion of desired surface into an energy harvesting surface, the micro-structures described above may be spread along the desired surface, preferably with an orientation suitable for optimized absorption. To this end, as described above, the micro-structure **10** may include an orientation region **18** including at least one orientation element / mechanism **180.** The orientation element is configured to respond to a predetermined external field (of a predetermined direction of the field vector) by generating a rotation force acting on the micro-structure **10** to thereby cause rotation thereof to an orientation in accordance with the selected direction of the external field. For example, the orientation element **180** may be a magnetic element, e.g. ferromagnetic metal (e.g. Cobalt, Iron) or mineral such as magnetite (Fe₃O₄), that can be desirably arranged with the magnetic field direction to allow proper orientation of an ensemble of micro-structures. The provision of orientation elements in the micro-structures allow for orientating the micro-structures while being located on the desired surface (and maintain this orientation at least for a short time after application of the micro-structures on the surface) such that the absorption regions **12** face out of the surface, e.g. the absorption arm extends away from the surface being substantially perpendicular to the surface, thereby maximizing light absorption by the micro-structures.

Additionally, the micro-structure may include two or more conduction-selective compounds (matrix materials) attached (e.g. via ligands) or in close proximity to the corresponding surface regions of the micro-structure. Generally, for the above-described anisotropic three-dimensional structure, the conduction-selective matrix materials include at least first and second matrix materials configured for transmission of negative and positive charge carriers respectively, thereby allowing charge collection from the micro-structure. This is exemplified in **Fig. 4** showing the micro-structure **10** where plurality of ligands **140** and **160** are attached to and extend from the respective regions of the micro-structure and connect to corresponding conduction-selective compounds (electron- and hole-conducting matrix materials). The conduction-selective compounds associated with ligands **140** and **160** may generally be a part of at least two types of polymeric or sol-gel and other materials.

These materials are selected such that first type compounds **140** enable selective transmission of electrons and second type compounds **160** allows selective transmission of holes. This selective transmission provides suitable charge collection from the micro-structures **10.** Thus, the electron-conducting matrix materials that are attached to the electron-conducting region **14** of the micro-structure **10** (via ligands **140**) assist in collection of electrons from the micro-structure **10,** and the hole-conducting matrix materials that are attached to the hole-conducting region **16** of the micro-structure **10** (e.g. via ligands **160**) assist in collection of holes from the micro-structure. It should be noted that the attached ligands may be used to provide selective charge transmission for the rod shaped micro-structure as shown in **Fig. 2A** or for any other chosen geometry in a substantially similar technique.

The first and second conduction-selective matrix materials may for example include Poly-3,4-ethylenedioxythiophene (PEDOT) and Poly-benzimidazobenzophenanthroline (BBL) molecular polymers. Additional suitable matrix materials include, but are not limited to, PDI, PCBM, ZnO (SolGel), TiO₂ (SolGel) for negative charge carrier (e.g. electrons) conducting and PDOT, BBB, CBP (LiTfsi doped), NiO, TPD (LiTfsi doped), Poly TPD (LiTfsi doped), Spiro OMETAD (LiTfsi doped) for positive charge carrier (e.g. holes) conductance. It should be noted that the first and second conduction-selective materials may also be polymeric compounds, other sol-Gel compounds, or according to some examples one or more porous materials (for example metal) or conductive aerogel with pore surfaces coated with hole or electron conduction-selective material while the pores being filled with the opposite carrier transport material (e.g. Ionic Liquids (ILs), Hole Transport Materials (HTMs) or Conductive Gels (CG)). It should also be noted that generally any set of materials that can form an interpenetrating conductive structure where both sets of materials are conducting, but electrically isolated from each other.

As indicated above, the first and second conduction-selective matrix materials are generally selected in accordance with their electronic transmission properties, as well as are based on their affinity to attach to the surface material of the micro-structures **10.** In order to specifically attach the matrix materials to the corresponding regions of the micro-structure, the different affinity between the micro-structure materials and the conduction-selective compounds might be used, or alternatively, but not only, the conduction-selective compounds can be specifically exchanged at a specific region by ligand exchange process in a Langmuir Blodgett film in an aqueous/organic interface.

According to some embodiments of the invention the micro-structures may be produced by growing seeded rods on a substrate and providing predetermined growth manipulations. The following is a non limiting example of a technique for producing light absorbing micro-structures according to some embodiments of the invention.

An inert and relatively smooth substrate, e.g. Si/SiO₂, glass, FTO, ITO, aluminum or any other suitable substrate, is covered with an N-type semiconductor seeding layer. The semiconductor may be ZnO applied on the surface by dip-coating the surface with Zn Sol-Gel solution, with or without doping agents, and drying and annealing the sol-gel. Utilizing thermal decomposition from aqueous solution, ZnO rods are grown from the seeding layer. When the rods are of the desired length, e.g. 100-500nm the substrate and rods is annealed. The rods are coated with a buffer insulating layer, e.g. silica or alumina, to form a depletion zone. The buffer insulating layer band may be applied on the rods by Chemical bath deposition (CBD) in aqueous solution or in organic solution or in any other suitable known method. Additional coating techniques include ion (e.g. cation) exchange, Successive Ionic Layer Adsorption and Reaction (SILAR), chemical vapor deposition (CVD) being aerosol assisted or not, sputtering and/or atomic layer deposition (ALD). In the ALD case, a Silicon and/or Aluminum precursor is preferably fed to the gas inlet tube of the ALD with water as the reaction agent to form a controlled layer of insulator layer on the rods.
After the buffer coating, the rods are coated by a thin layer of P-type semiconductor, such as CuO. This coating may be done by CBD in aqueous and/or organic solution. Alternative methods for semiconductor coating include cation exchange, AA-CVD, sputtering, SILAR and/or ALD. As indicated above, utilizing ALD coating technique generally includes feed of a CuO precursor to the gas inlet tube of the ALD, together with water as the reaction agent to form a controlled layer of CuO on the rods. This semiconductor coating provides heterostructres having an interface region and two or more regions of different electronic properties. After coating, the heterostructres are removed off the surface of the seeding substrate. This may be performed by mechanical peeling, chemical etching of the substrate, sonication or any other suitable method. The heterostructres may then be dispersed in solution and subsequently re-suspended in solution by additional sonication.

If needed one of the semiconductors of the heterostructure, e.g. the ZnO region, may be further grown. This may be done using the exposed seeding layer of ZnO as additional seed for further growth at the opposite side of the hetero-structured rods. Additional such growing methods can be used to generate the three-dimensional anisotropic micro-structure described above.

Being light absorbing, the micro-structures may be used as a pigment in paint-like liquid mixture/substance. The liquid mixture includes plurality of micro-structures as described above, immersed in a liquid solution. The liquid solution is configured to allow simple coating thereof on a desired surface, while drying within an appropriate time period after being exposed to air. Additionally, the liquid mixture may include plurality of compounds (e.g. with corresponding ligands) of at least the first and second conduction-selective types. The conduction-selective compounds are capable of interacting electronically (for example attaching via ligands) to the corresponding regions of the micro-structure while in the liquid solution, or upon hardening thereof. The liquid mixture may be configured to be dried within a suitable time period after being exposed to air, or alternatively the liquid mixture may be configured such that it requires an appropriate processing/treatment in order to properly dry or cure. Such process/treatment may include heating of the painted surface to anneal and assist drying (e.g. when using PEDOT) and/or radiating the surface with Ultra-Violet illumination to cure and fix the mixture components and/or using SolGel technique (e.g. for ZnO electron conductance).

It should be noted that the liquid solution may include an aqueous solution, and/or suitable organic solvent and/or suitable oil in accordance with material properties (for example the properties of the desired surfaces to be applied on). Additionally, according to some embodiments, the liquid mixture may include one or more materials selected to prevent aggregation of the micro-structures.

As indicated above, generally, any electrically non-conductive surface may be converted to an energy harvesting surface utilizing input electromagnetic radiation to generate electrical energy. Such surface conversion generally includes application thereon of a layer of the micro-structures' containing liquid mixture, (together with an appropriate electrical circuit for reading out the generated electrical energy). According to some embodiments, the liquid mixture may be left to dry in air for a few minutes, or it may undergo appropriate curing utilizing for example UV radiation, electrical bias or heating.

Additionally, according to some embodiments, the micro-structures may be configured for alignment within the layer by application of an external field with a desired direction and magnitude. As described above, the external field may be a magnetic field generated by a suitable magnetic field source (e.g. permanent magnet or electro-magnet). The orientation element located at the orientation region of the micro-structure responds to the external (magnetic) field by applying a rotation force on the micro-structure thereby aligning / orienting the micro-structure along an axis determined by the direction of the field. As indicated above, for a core-shell cylinder like absorption region, the micro-structures are preferably aligned such that the absorption region containing arm of the micro-structure extends substantially perpendicular with respect to the corresponding surface, to optimize absorption of input light.

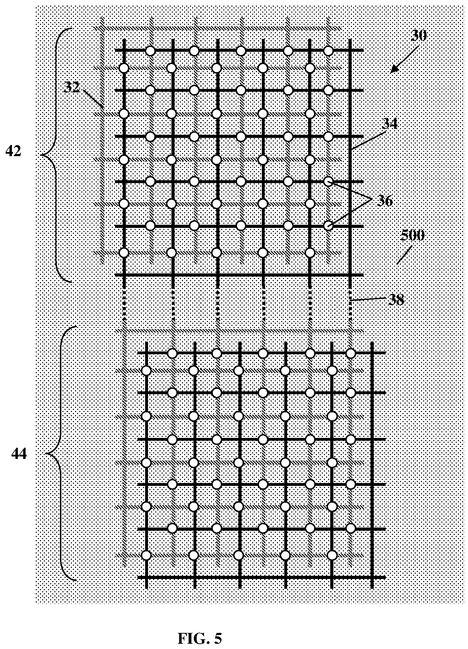

Reference is made to **Fig. 5** illustrating an electric circuit for reading-out or collection of the generated electric energy from a painted "photo-voltaic" surface **500** according to the technique of the present invention. The electric curtain is configured as an electrode arrangement **30,** including conducting wires arranged in the form of nets covering zones of predetermined area, two such zones **42** and **44** being shown in the present example. The electrode arrangement **30** is configured to be stretched (rolled out) along the surface, and is generally formed by at least two sets of conducting wires **32** and **34.** The at least two sets of conducting wires are pre-treated to selectively allow collection of charge carriers from the medium in the surroundings. This pre-treatment may include coating of the first set **32** of conducting wires with a material allowing transmission of negative charge carriers (e.g. electrons) from the surroundings, while blocking transmission of positive charge carriers (e.g. holes). Such coating may be, but not restricted to, with a thin layer of n-ZnO on the surface of the wires, additional negative charge selective materials may also be used. The second set **34** of conducting wires is similarly treated to allow transmission of holes while blocking electron transmission, for example, but not limited to, by a thin layer of Nickel Oxide (NiO), additional positive charge selective materials may also be used. The different sets are arranged to form of a net along the surface so as to provide a predetermined maximal distance between all of the micro-structures and the nearest electrode. For example the first **32** and second **34** sets of wires may be configured in the form of a net having distance of between 1 micron to 1 millimeter between adjacent wires, and preferably about 0.5 millimeter between adjacent wires of the opposite set. Since each of the electron blocking and hole blocking layers generally constitute isolating layers, the at least two sets of conducting wires may generally overlay about each other at meeting points **36.** This allows selective collection of charge carriers along a wide surface while preventing loss of collected energy due to short circuits. Additionally or alternatively, isolating material such as plastic or other polymers may be introduced in the intersection points to secure the prevention of short circuits that may occur for example due to friction during assembly.

As indicated, the electrode arrangement **30** may be configured to cover plurality of collection zones/regions **42** and **44.** Within each of the collection zones the different conducting wires **32** and **34** are insulated from each other to provide a certain voltage between them. This is while at a transition between zones **38,** the negative charges collecting conductive wire of one zone, e.g. zone **42,** is electrically connected to the positive charges collecting conductive wire of the adjacent zone, e.g. zone **44.** Thus, within each of the collection zones, the different sets of conducting wires are insulated from each other, while being connected in series between the zones. This configuration of the electrode arrangement allows for accumulation of electric voltage generated by charge collection along the surface.

It should be noted that the configuration of the electrode arrangement exemplified in **Fig. 5** provides for highly robust electric collection setup. The internal connections between the sets of conducting wires allow the energy collection even if the surface being covered is not continuous, e.g. if a perforation occurs in the net structure. This feature of the electrodes arrangement allows for using the above described technique of the invention on any surface exposed to photon radiation, including buildings' walls, while allowing discontinuity in the walls, e.g. for windows or nails used for hanging, without limiting the charge collection.

Selective charge collection within each zone may generally be provided by coating the different conducting wires with suitable negative charge blocking (e.g. electrons-blocking) and positive charge blocking (e.g. hole-blocking) blocking layers. The said blocking layers may be for example polymeric materials such as PEDOT, Polypyrrole (PPy), Poly (p-phenylene) (PPP) and Poly (benzimidazobenzophenanthroline) (BBL), suitable semiconductors such as ZnO and NiO or any other charge selective material as described above. The wires may be coated as well, with any of the micro-structure materials described above, as a crystalline coating or as a dispersion of poly crystalline in a polymer matrix, among other techniques. Also, the electric circuit may further include various electronic elements, such as supercapacitors, configured for storing at least a portion of the collected energy. For example, the conducting wires of the electrode arrangement may include portions thereof, which are configured in a coaxial fashion thereby providing a predetermined capacitance between an outer conducting shell and an inner conducting axial segment. Collected electric energy may be stored for further use, e.g. during time intervals when less electromagnetic radiation falls on the surface (passing cloud, etc.).

According to some examples, coating the wires with a positive charge (e.g. hole) blocking or electronegative charge (e.g. electron) blocking coating may be provided by dip coating, sputtering, ALD, spray coating, CBD or other techniques. For example, coating of aluminum wires with suitable semiconductor coating may be provides by dipping the wire in a zincate solution, to exchange the aluminum outer layer with a layer of zinc and then annealing the wire in a furnace in the presence of oxygen in order to create a ZnO layer that blocks hole conduction. Such ZnO coating may be in thickness of 5-5000nm, and preferably, in thickness of 50-1000nm. It should be noted that such ZnO coating may provide additional precursor for growth of ZnO based microstructures as described above. Generally the ZnO coating layer may be used as seed of particle growth. The particles may undergo further growth of a different material (e.g. CuO) to provide a heterostructure as described above. This technique provides for already connected micro-structures providing highly efficient current collection by the electrode arrangement.

Similarly, coating of aluminum wires with an electron blocking can be provided utilizing a nickel coating, or NiO coating. For example, A Nickel layer may be applied on an aluminum wire by a nickel plating technique and then anneal it in the presence of oxygen to form an NiO electron blocking layer, preferably in thickness of 5-20nm. Additional coating may be applied to provide enhanced electron blocking properties. For example, the NiO coated wires may be further coated with a layer of PEDOT having thickness of 500nm and up to 50 microns, preferably of 1 micron. The additional coating layer provides friction protection to the NiO. As well as protect this layer from other damaging effects. Generally any conductive material may be used for the wires as long as the electronic arrangement is suitable. It can even be a plastic wire coated with a conductive substance for example.

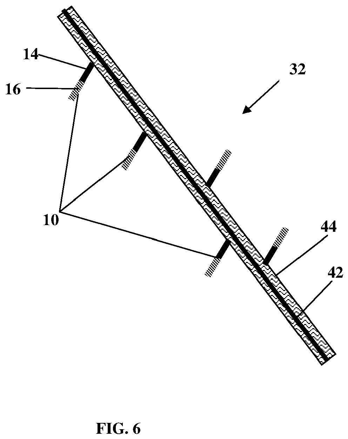

Reference is made to **Fig. 6** illustrating a part of a conducting wire **32** configured by a metal wire **42** coated by selective conduction coating **44.** Plurality of micro-structures **10** according to the present invention are grown on the selective conduction coating **44.** In this connection the inner wire **42** may be aluminum or any other suitable conducting material. The wire is coated by a layer of ZnO **44** and the coating is used as seed for growth of micro-structures **10** as described above. In this example the micro-structures have first region **14** formed of ZnO and a second region **16** formed of CuO. It should also be noted that the inner wire **42** itself may be formed of Zinc instead of aluminum. This variation simplifies the coating process and the production of Zincate for coating **44** of the wire **42.** It should be noted that such material selection is not limited to the use of Zinc and ZnO. Generally, the wires may be formed of any suitable conductive material and coated by charge selective conductive material. Moreover, the wires **32** and **34** may be configured by any material where the metallic element (or a conductive version, e.g. suitable doping) has a charge selective conducting variation (e.g. oxide or any other appropriate compound, or intrinsic doping). Generally any conductive material may be used for the wires as long as the electronic arrangement is suitable. Also, the wires **32** and **34** may be formed of a plastic wire coated with a conductive substance for example.

It should be noted that the conducting wires are generally configured to minimize Ohmic losses. Thus, the conducting wires are preferably made of highly conducting material, e.g. aluminum, zinc or copper wires, and are configured to be wide enough to reduce resistance for electric currents. It should also be noted that the electrode arrangement may be connected, by its two said sets of wires, to suitable standard PV equipment such as MPPTs, AC/DC converters, inverters, batteries etc.

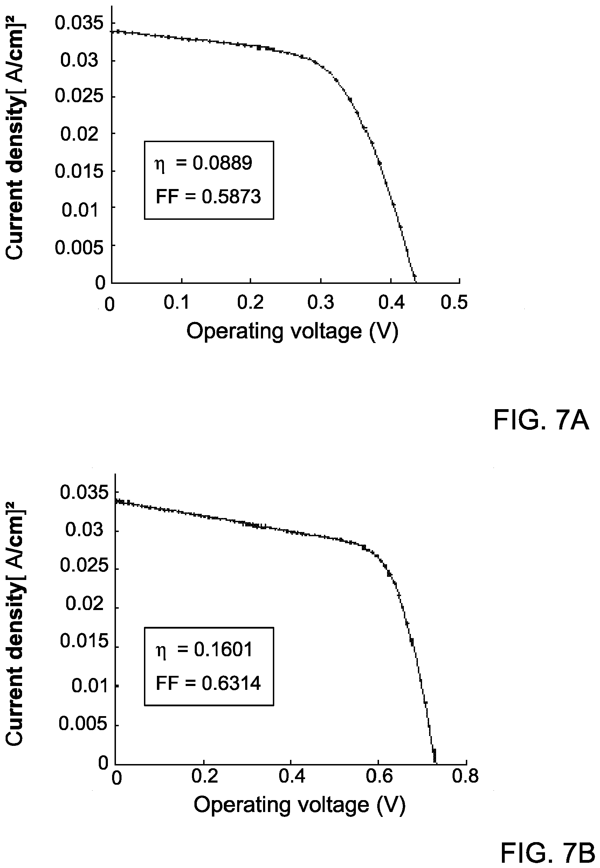

Reference is made to **Figs. 7A-7B** illustrating simulated current density as a function of voltage diagrams (J/V) exemplifying the conversion efficiency of the technique of the present invention. **Fig. 7A** shows a J-V (current density vs. voltage) simulated curve and solar to electricity conversion efficiency (η) and fill factor (FF) of 0.58 based on measured dark current from a ZnO/CuO junction. **Fig. 7B** shows results for improved junction quality of ZnO/CuO junction which may provide increased efficiency and fill factor (FF).

The present invention also provides a kit for use in surface preparation for photo-voltaic conversion. The kit may generally include the above described liquid mixture, including the micro-structures immersed therein, and an electric circuit including the above described electrode arrangement for collection of the generated electrical power. The kit may also include a paint curing unit suitable for performing curing of the paint material after application on a desired surface, as well as an orientation field source configured to generate a desired external field suitable for aligning the micro-structures as described above.

The curing unit, if used, may include a UV light source for applying UV radiation of appropriate parameters to the painted surface, and/or electrical bias, and/or a heat source, e.g. heating coil and fan, configured for providing thermal energy to the painted surface thereby accelerating its drying process. The UV light source and/or heating and/or curing reagent may for example be used to polymerize the appropriate materials in the liquid mixture.

The orientation field source/generator may be, as described above, a magnetic field source configured to generate a magnetic field having desired intensity/profile and direction. The use of alignment of the micro-structures with the desired orientation thereof with respect to the painted surface is aimed at maximizing light conversion by arranging the micro-structures such as to orient the absorption region of the micro-structures to extend from the surface substantially perpendicular thereto. It should be noted that the orientation/alignment of the micro-structures is preferably performed prior to curing the liquid mixture, or when the paint material is partially cured.

According to some embodiments, curing of the liquid mixture / paint material may be performed, partially or fully, by transmitting appropriate electrical current through the electrode arrangement after setting the electrodes and applying the mixture on the surface. The electrical current may be opposite to the preferred direction of collection of current, thereby generating heat and electrical field through the electrode arrangement and the paint materials.

Thus, the present invention provides a novel technique and required elements for conversion of any non-conductive surface, exposable to electromagnetic radiation, into electromagnetic radiation harvesting surface. The use of paint material with suitable micro-structures allows for simple conversion process and provides solar harvesting capabilities to practically any surface exposed to radiation. The invention also provides an effective electric circuit for collection of the generated electric energy.

## Claims

1. An electrode arrangement comprising at least two sets of conducting wires (32, 34) comprising different wires with coatings configured to allow transmission of charge carriers of two different types respectively, from a medium in surroundings thereof, wherein said at least two sets of conducting wires are arranged in the form of a grid such that the different wires adjacent to one another define a region of charge collection, and are insulated from one another in said region of charge collection; wherein the different wires of said at least two sets are coated with selective charge carriers blocking layers (44), respectively.

2. The electrode arrangement of Claim 1, wherein the wires of said at least two sets of conducting wires are weaved together within the region of collection.

3. The electrode arrangement of Claim 1 or 2, being configured for defining a plurality of the collection regions, such that within each of the collection regions said at least two sets of conducting wires are insulated from each other, and said at least two sets of conducting wires are connected in series between said collection regions to thereby provide accumulating voltage of charge collection.

4. The electrode arrangement of any one of Claims 1 to 3, wherein at least one of said at least two sets of wires is coated with a selective charge carriers blocking material comprising at least one material selected from: unary, binary or ternary n-type semiconductor of groups IV, II-V, II-VI, PEDOT, PDI, PCBM, ZnO, TiO₂ n-doped Tin Oxide.

5. The electrode arrangement of any one of Claims 1 to 4, wherein at least one of said at least two sets of wires is coated with a selective charge carriers blocking material comprising at least one material selected from: unary, binary or ternary p-type semiconductor of groups IV, III-V, II-VI, BBL, PDOT, BBB, CBP (LiTfsi doped), NiO, TPD (LiTfsi doped), Poly TPD (LiTfsi doped), Spiro OMETAD (LiTfsi doped) p-doped Tin oxide.

6. The electrode arrangement of any one of Claims 1 to 5, configured to define a plurality of the collection regions, arranged such that between each adjacent collection regions said at least two sets of conducting wires are alternating with respect to selective charge collection.

7. The electrode arrangement of any one of Claims 1 to 6, wherein said conducting wires are configured as coaxial conducting wires having predetermined capacitance between an outer conducting shell and an inner conducting axial segment thereof, said coaxial conducting wires are configured for storing excess of electrical energy for further use.

8. The electrode arrangement of any one of the preceding Claims, wherein at least one of said at least two sets of wires comprises charge selective coating and wherein a plurality of micro-structures (10) is grown from said charge selective coating; said plurality of micro-structures being configured for absorption of light of a predetermined wavelength range and causing charge separation to thereby allow collection of charge carriers through said at least one of the at least two sets of wires.

9. The electrode arrangement of Claim 8, wherein said at least one of said at least two sets of wires is coated with ZnO, said micro-structures comprising at least one region formed of ZnO being attached to said coating.

10. The electrode arrangement of Claim 8, wherein said at least one of said at least two sets of wires is coated with titania, said micro-structures comprising at least one region formed of titania being attached to said coating.

11. The electrode arrangement of Claim 10, wherein said at least one region is formed of ZnO and coated by titania.

12. A kit for use in preparation of a photo-voltaic surface, the kit comprising:
an electrode arrangement configured according to any one of claims 1 to 11 for placing on a surface (100); and
a paint material applicable on an electrically insulating surface, the paint material comprising a liquid substance with an immersed plurality of anisotropic micro-structures configured for absorbing input light of a predetermined wavelength range and generating, in response, electron-hole pairs of free charge carriers, and charge selective compounds configured to attach to selective regions of the anisotropic micro-structures, and to allow conduction of, respectively, electrons and holes from the anisotropic micro-structures, application of said paint material to the surface resulting in dispersion of the micro-structures within said surface and attachment to said surface upon hardening the paint material; wherein when the paint material is applied to the surface on which the electrode arrangement is placed, the electrode arrangement defines an array of charge collection regions for collecting the charge generated in response the input light absorbed by the micro-structures.

13. The kit of Claim 12, further comprising a source of a predetermined field configured and operable for applying said field to the surface with the paint material thereof to thereby affect orientation of said anisotropic micro-structures to align them in a desired orientation.

14. The kit of Claims 12 or 13, further comprising a paint hardening unit configured and operable for applying heat to the surface with the paint material thereon.

## Patentansprüche

1. Elektrodenanordnung, die zumindest zwei Sätze von Leitungsdrähten (32,34) umfasst, die unterschiedliche Drähte mit Beschichtungen umfassen, die ausgelegt sind, um eine Übertragung von Ladungsträgern jeweils zweier unterschiedlicher Typen aus einem Medium in dessen Umgebung zu ermöglichen, wobei die zumindest zwei Sätze von Leitungsdrähten in Form eines Gitters derart angeordnet sind, dass die zueinander benachbarten unterschiedlichen Drähte einen Bereich der Ladungssammlung definieren und im Bereich der Ladungssammlung voneinander isoliert sind;
wobei die unterschiedlichen Drähte der zumindest zwei Sätze jeweils mit selektiven Ladungsträgerblockierschichten (44) beschichtet sind.

2. Elektrodenanordnung nach Anspruch 1, wobei die Drähte der zumindest zwei Sätze von Leitungsdrähten im Sammelbereich miteinander verwoben sind.

3. Elektrodenanordnung nach Anspruch 1 oder 2, die zum Definieren einer Vielzahl der Sammelbereiche ausgelegt ist, so dass innerhalb jedes der Sammelbereiche die zumindest zwei Sätze von Leitungsdrähten voneinander isoliert sind, und die zumindest zwei Sätze von Leitungsdrähten in Reihe zwischen den Sammelbereichen geschaltet sind, um dadurch eine Akkumulationsspannung der Ladungssammlung bereitzustellen.

4. Elektrodenanordnung nach einem der Ansprüche 1 bis 3, wobei zumindest einer der zumindest zwei Sätze von Drähten mit einem selektiven Ladungsträgerblockiermaterial beschichtet ist, das zumindest ein Material umfasst, das aus: unärem, binärem oder ternärem n-Typ-Halbleiter der Gruppen IV, II-V, II-VI, PEDOT, PDI, PCBM, ZnO, TiO₂ n-dotiertes Zinnoxid ausgewählt ist.

5. Elektrodenanordnung nach einem der Ansprüche 1 bis 4, wobei zumindest einer der zumindest zwei Sätze von Drähten mit einem selektiven Ladungsträgerblockiermaterial beschichtet ist, das zumindest ein Material umfasst, das aus: unärem, binärem oder ternärem p-Typ-Halbleiter der Gruppen IV, III-V, II-VI, BBL, PDOT, BBB, CBP (LiTfsi dotiert), NiO, TPD (LiTfsi dotiert), POLY TPD (LiTfsi dotiert), Spiro OMETAD (LiTfsi dotiert) p-dotiertes Zinnoxid ausgewählt ist.

6. Elektrodenanordnung nach einem der Ansprüche 1 bis 5, die ausgelegt ist, um eine Vielzahl der Sammelbereiche zu definieren, die so angeordnet sind, dass sich zwischen jedem benachbarten Sammelbereich die zumindest zwei Sätze von Leitungsdrähten in Bezug auf eine selektive Ladungssammlung abwechseln.

7. Elektrodenanordnung nach einem der Ansprüche 1 bis 6, wobei die Leitungsdrähte als koaxiale Leitungsdrähte mit vorbestimmter Kapazität zwischen einer äußeren leitenden Hülle und einem inneren leitenden Axialsegment davon ausgebildet sind, wobei die koaxialen Leitungsdrähte zur Speicherung von Überschuss an elektrischer Energie zur weiteren Verwendung ausgelegt sind.

8. Elektrodenanordnung nach einem der vorhergehenden Ansprüche, wobei zumindest einer der zumindest zwei Sätze von Drähten eine ladungsselektive Beschichtung umfasst, und wobei sich eine Vielzahl von Mikrostrukturen (10) aus der ladungsselektiven Beschichtung herausgebildet hat: welche Vielzahl von Mikrostrukturen zur Absorption von Licht eines vorbestimmten Wellenlängenbereichs ausgelegt ist und eine Ladungstrennung bewirkt, um dadurch eine Sammlung von Ladungsträgern durch den zumindest einen der zumindest zwei Sätze von Drähten zu ermöglichen.

9. Elektrodenanordnung nach Anspruch 8, wobei der zumindest eine der zumindest zwei Sätze von Drähten mit ZnO beschichtet ist, wobei die Mikrostrukturen zumindest einen Bereich umfassen, der aus an der Beschichtung befestigtem ZnO gebildet ist.

10. Elektrodenanordnung nach Anspruch 8, wobei der zumindest eine der zumindest zwei Sätze von Drähten mit Titandioxid beschichtet ist, wobei die Mikrostrukturen zumindest einen Bereich umfassen, der aus an der Beschichtung befestigtem Titandioxid gebildet ist.

11. Elektrodenanordnung nach Anspruch 10, wobei der zumindest eine Bereich aus ZnO gebildet und mit Titandioxid beschichtet ist.

12. Kit zur Verwendung bei der Herstellung einer Photovoltaik-Oberfläche, welches Kit umfasst:
eine nach einem der Ansprüche 1 bis 11 ausgebildete Elektrodenanordnung zum Aufsetzen auf eine Oberfläche (100); und
ein auf eine elektrisch isolierende Oberfläche auftragbares Lackiermaterial, wobei das Lackmaterial eine flüssige Substanz mit einer eingetauchten Vielzahl von anisotropen Mikrostrukturen umfasst, die dazu ausgelegt sind, Eingangslicht eines vorbestimmten Wellenlängenbereichs zu absorbieren, und, in Reaktion darauf, Elektron-Loch-Paare von freien Ladungsträgern und ladungsselektiven Verbindungen zu erzeugen, die dazu ausgelegt sind, an selektiven Bereichen der anisotropen Mikrostrukturen befestigt zu werden, und das Leiten von jeweils Elektronen und Löchern aus den anisotropen Mikrostrukturen, das Auftragen des Lackmaterials auf die Oberfläche, was zu einer Dispersion der Mikrostrukturen innerhalb der Oberfläche führt, und das Befestigen an der Oberfläche beim Aushärten des Lackmaterials zu ermöglichen;
wobei beim Auftragen des Lackmaterials auf die Oberfläche, auf der die Elektrodenanordnung angeordnet ist, die Elektrodenanordnung ein Array von Ladungssammelbereichen zum Sammeln der erzeugten Ladung in Reaktion auf das von den Mikrostrukturen absorbierte Eingangslicht definiert.

13. Kit nach Anspruch 12, ferner umfassend eine Quelle eines vorbestimmten Feldes, die ausgelegt und bereit ist, um das Feld auf die Oberfläche mit dem Lackmaterial davon aufzutragen, um dadurch auf die Orientierung der anisotropen Mikrostrukturen einzuwirken, um sie in einer gewünschten Orientierung auszurichten.

14. Kit nach Anspruch 12 oder 13, ferner umfassend eine Lackhärtungseinheit, die zum Auftragen von Wärme auf die Oberfläche mit dem Lackmaterial darauf ausgelegt und bereit ist.

## Revendications

1. Agencement d'électrodes comprenant au moins deux ensembles de fils conducteurs (32,34) comprenant des fils différents avec des revêtements configurés pour permettre la transmission de porteurs de charge de deux types différents, respectivement, depuis un milieu dans leur voisinage, dans lequel lesdits au moins deux ensembles de fils conducteurs sont disposés sous la forme d'une grille si bien que les différents fils adjacents les uns des autres définissent une région de collecte de charges et sont isolés les uns des autres dans ladite région de collecte de charges ;
dans lequel les différents fils des au moins deux ensembles sont respectivement revêtus de couches bloquant des porteurs de charge sélectifs (44).

2. Agencement d'électrodes selon la revendication 1, dans lequel les fils desdits au moins deux ensembles de fils conducteurs sont tissés ensemble dans la région de collecte.

3. Agencement d'électrodes selon la revendication 1 ou 2, étant configuré pour définir une pluralité de régions de collecte, si bien qu'à l'intérieur de chacune des régions de collecte, lesdits au moins deux ensembles de fils conducteurs sont isolés l'un de l'autre et lesdits au moins deux ensembles de conducteurs de fils sont connectés en série entre lesdites régions de collecte afin de fournir ainsi une tension accumulée de collecte de charge.

4. Agencement d'électrodes selon l'une quelconque des revendications 1 à 3, dans lequel au moins l'un desdits au moins deux ensembles de fils est revêtu d'un matériau bloquant des porteurs de charge sélectif, comprenant au moins un matériau choisi parmi: un semi-conducteur de type n unaire, binaire ou ternaire des groupes IV, II-V, II-VI, PEDOT, PDI, PCBM, ZnO, oxyde d'étain TiO₂ n dopé.

5. Agencement d'électrodes selon l'une quelconque des revendications 1 à 4, dans lequel au moins l'un desdits au moins deux ensembles de fils est revêtu d'un matériau bloquant des porteurs de charge sélectif, comprenant au moins un matériau choisi parmi: un semi-conducteur unaire, binaire ou ternaire de type p des groupes IV, III-V, II-VI, BBL, PDOT, BBB, CBP (dopé au LiTfsi), NiO, TPD (dopé au LiTfsi), Poly TPD (dopé au LiTfsi), Spiro OMETAD (dopé au LiTfsi) oxyde d'étain p dopé.

6. Agencement d'électrodes selon l'une quelconque des revendications 1 à 5, configuré pour définir une pluralité de régions de collecte, agencé de sorte que, entre chaque région de collecte adjacente, lesdits au moins deux jeux de fils conducteurs alternent par rapport à la collecte sélective de charges.

7. Agencement d'électrodes selon l'une quelconque des revendications 1 à 6, dans lequel lesdits fils conducteurs sont configurés en tant que fils conducteurs coaxiaux ayant une capacité prédéterminée entre une enveloppe conductrice extérieure et un segment axial conducteur intérieur de celle-ci, lesdits fils conducteurs coaxiaux étant configurés pour stocker un excès d'énergie électrique pour d'autres utilisations.

8. Agencement d'électrodes selon l'une quelconque des revendications précédentes, dans lequel au moins l'un desdits au moins deux ensembles de fils comprend un revêtement sélectif de charge, et dans lequel une pluralité de micro-structures (10) sont développées à partir dudit revêtement sélectif de charges ; ladite pluralité de micro-structures étant configurées pour absorber la lumière dans une plage prédéterminée de longueurs d'onde et provoquer la séparation de charge pour permettre ainsi la collecte de porteurs de charge à travers ledit au moins un des au moins deux ensembles de fils.

9. Agencement d'électrodes selon la revendication 8, dans lequel ledit au moins un desdits au moins deux ensembles de fils est revêtu de ZnO, lesdites micro-structures comprenant au moins une région formée de ZnO étant attachée audit revêtement.

10. Agencement d'électrodes selon la revendication 8, dans lequel ledit au moins un desdits au moins deux ensembles de fils est revêtu de Titania, lesdites micro-structures comprenant au moins une région formée de Titania étant attachée audit revêtement.

11. Agencement d'électrodes selon la revendication 10, dans lequel ladite au moins une région est formée de ZnO et revêtue de Titania.

12. Kit destiné à être utilisé dans la préparation d'une surface photovoltaïque, le kit comprenant :
un agencement d'électrodes configuré selon l'une quelconque des revendications 1 à 11 destiné au placement sur une surface (100) ; et
un matériau de peinture applicable sur une surface électriquement isolante, le matériau de peinture comprenant une substance liquide avec une pluralité de micro-structures anisotropes immergées configurées pour absorber la lumière d'entrée d'une gamme prédéterminée de longueurs d'onde et générant, en réponse, des paires électron-trou de porteurs de charge libre, et composés sélectifs de charge configurés pour se fixer à des régions sélectives des micro-structures anisotropes, et pour permettre la conduction, respectivement, des électrons et des trous issus des micro-structures anisotropes, l'application du matériau de peinture sur la surface entraînant la dispersion des micro-structures dans ladite surface et la fixation à ladite surface lors du durcissement du matériau de peinture ;
dans lequel, lorsque le matériau de peinture est appliqué sur la surface sur laquelle est disposé l'agencement d'électrodes, l'agencement d'électrodes définit un ensemble de régions de collecte de charges pour collecter la charge générée en réponse à la lumière d'entrée absorbée par les micro-structures.

13. Kit selon la revendication 12, comprenant en outre une source d'un champ prédéterminé configurée et utilisable pour appliquer ledit champ à la surface avec le matériau de peinture de celui-ci pour affecter ainsi l'orientation desdites micro-structures anisotropes afin de les aligner dans une orientation souhaitée.

14. Kit selon les revendications 12 ou 13, comprenant en outre une unité de durcissement de peinture configurée et pouvant fonctionner pour appliquer de la chaleur à la surface avec le matériau de peinture sur celle-ci.
